# EUROPEAN PATENT APPLICATION

(11) **EP 1 731 806 A1**
(43) Date of publication of application: **13.12.2006**
(21) Application number: 06252859.1
(22) Date of filing: 02.06.2006
(51) Int. Cl.: F16K 3/02, H01J 37/32

(54) **Dual gate isolating valve**

(30) Priority: 10.06.2005 US 150360
(71) Applicant: Applied Films Corporation, Longmont, CO 80504 (US)
(72) Inventor: Petrach, Philip M., Napa, CA 94558 (US); Belgarde, Wayne M., Clayton, CA 94517 (US); Strahlendorf, Michael L., Oakley, CA 94561 (US)
(74) Representative: Hitchcock, Esmond Antony

(57) **Abstract**

In a coater for applying layers on large substrates, isolation between portions of the coater is provided by dual gate slit valve chambers. A dual gate slit valve has one gate on either side of a wall that has an opening. Gates are clear of the opening in the open position and cover the opening from both sides in the closed position. When one side of the dual gate slit valve chamber is at atmospheric pressure and the other is under vacuum, atmospheric pressure helps to keep the slit valve sealed by pushing one gate against the wall. This works regardless of which side of the valve is at atmosphere. One or more pumps may be mounted on the slit valve chamber.

## Description

The present invention relates to vacuum systems used in coating large substrates and in particular to providing isolation between portions of such systems during maintenance.

Large substrates, such as sheets of architectural glass may be coated with a variety of materials to modify their optical, thermal and aesthetic qualities. For example, an optical coating may be used to reduce the transmission of visible light (a solar control coating), decrease absorption of energy (a low-emissivity coating), or reduce reflectance (an anti-reflective coating). U.S. Patent No. 6,589,657 entitled "Anti-reflection Coatings and Associated Methods" and U.S. Published Patent Application No. 2003/0043464 entitled "Optical Coatings and Associated Methods," both of which are hereby incorporated by reference in their entirety, describe the formation and use of coatings that affect the optical characteristics of a glass substrate.

Coating large substrates such as architectural glass presents particular problems. Architectural glass is generally produced in large sheets measuring up to 3.2 meters by 6 meters (126 inches by 236 inches). Such sheets are difficult to handle. Coating systems (coaters) generally consist of multiple process modules (chambers) arranged in series so that a substrate can pass from one process module to the next. Substrates are generally moved by rollers that also support the substrates. The substrate generally enters the coater at one end and passes through multiple process modules where it is coated with different materials. Substrates may be oriented so that they are horizontal and are moved along a horizontal plane, though in other systems substrates are arranged in vertical or near vertical orientations.

One common coating process is sputtering of a target material from a cylindrical target onto the substrate as the substrate moves past the target. Sputtering generally takes place in a vacuum environment. Coating large substrates such as large sheets of glass using cylindrical magnetrons presents particular problems. The large substrates must be moved past the target under vacuum while the target rotates and while target material is sputtered. This requires maintaining a vacuum environment for sputtering but also enabling moving parts within the vacuum environment. In addition, a high power electrical supply is needed for sputtering and cooling water is needed to prevent excessive heating. Systems and methods of depositing materials in this way are described in U.S. Patent No. 6,736,948 entitled "Cylindrical AC/DC Magnetron with Compliant Drive System and Improved Electrical and Thermal Isolation," which patent is hereby incorporated by reference in its entirety.

The term vacuum may refer to a gas at any pressure below atmospheric pressure. In general, sputtering processes for coating glass are carried out in the millitorr range. In some processes, a chosen gas is introduced into the sputtering compartment to allow reactive sputtering to take place. This uses the gas in combination with the sputtered target material to form a layer on a substrate. The amount of gas introduced is generally small so that the pressure remains well below atmospheric pressure and the compartment may still be considered to be under vacuum.

It is sometimes necessary to access the inside of a coater. For example, targets need to be replaced periodically, cleaning may be needed to remove buildup of material that deposits on the interior of the coater and maintenance procedures may be needed to keep the coater operating within acceptable limits or replace broken components. Accessing the interior of a coater requires bringing the coater, or a portion of it, to atmospheric pressure. However, because of the large scale of a coater, it is generally preferred to vent (bring to atmospheric pressure) only a part of the coater while keeping the rest of the coater under vacuum. This serves two purposes. Firstly, it reduces the pumping needed to return the coater to vacuum because the volume that is vented is smaller. Secondly, the exposure of the interior of the coater to air is limited. This may be important for processes that are sensitive to contamination by moisture. In general, exposure to air is bad for the interior portions of the coater because contaminants may be introduced.

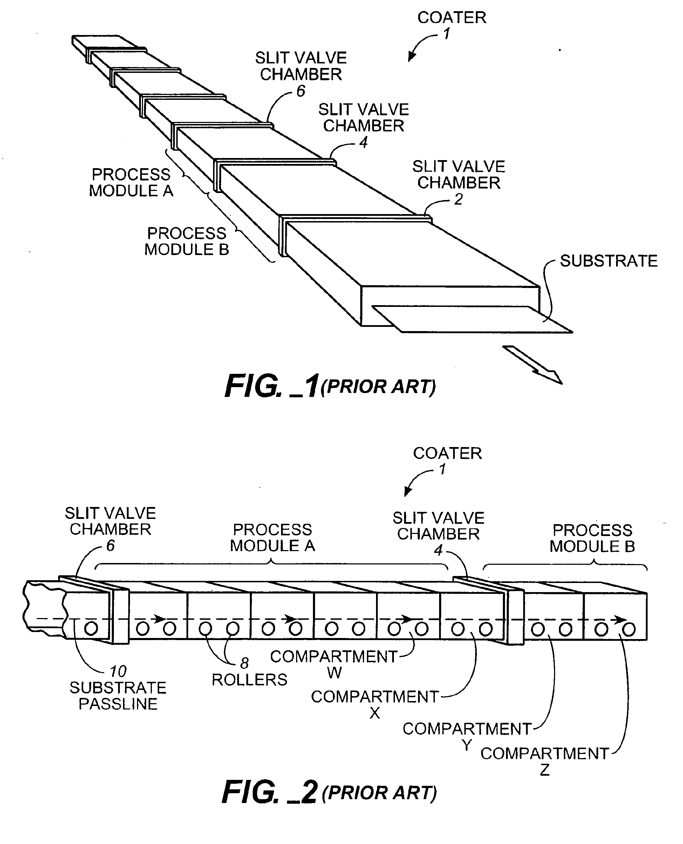

In order to allow a portion of the coater to be vented while keeping the remainder of the coater under vacuum, maintenance slit valves may be provided at certain points in the coater. A typical slit valve has an elongated opening through a wall or partition through which a substrate can pass when the slit valve is open. When the slit valve is closed, a gate (a metal plate of appropriate size) is placed across the elongated opening to close it. An o-ring located between the gate and the surface around the opening provides a seal between the gate and wall. A maintenance slit valve in a coater may be located in a slit valve chamber located between process modules. Maintenance slit valves in coaters are normally open during processing to allow substrates to pass through the system along the substrate passline (the path through the coater along which substrates are moved by rollers). For a coater with many process modules, maintenance slit valve chambers may be located at regular intervals along the substrate passline. However, slit valves add to the cost of a coater and require additional space. The space needed may be a critical factor because coaters may be several hundred feet long and generally require large production areas, which are expensive to provide and maintain. Therefore, reducing the size of coaters, especially reducing the overall length in the substrate passline direction is desirable. Figure 1 shows an example of a coater 1 having maintenance slit valve chambers 2, 4, 6 located at intervals to isolate process modules during maintenance.

Figure 2 shows a side view of coater 1 of Figure 1. Figure 2 shows process module A that contains 6 compartments (bays). An individual compartment may be configured to deposit a layer onto a substrate (for example by sputtering) or may be configured for some other purpose such as pumping. Pump compartments have one or more pumps attached. One arrangement is to have pumps attached to the top of a pump compartment with backing pumps nearby. Typically, pump compartments are interspersed between sputtering compartments to provide the desired vacuum levels.

It is generally desirable to reduce gas flow between process modules during processing. Processes that are highly incompatible may be located in adjacent process modules (generally, such incompatible processes are not located in the same process module). For example, a reactive sputtering process that produces an oxide layer by sputtering in an oxygen environment may be located in an adjacent process module to a process that is sensitive to oxygen contamination. To reduce cross-contamination between adjacent process modules, vacuum pumps are located at either side of the slit valve chamber. Thus, any contaminant produced by a process in one process module is likely to be pumped out of the coater before it reaches the slit valve chamber or the adjacent process module. For example, Figure 2 shows compartments W and X in process module A on one side of slit valve chamber 4 and compartments Y and Z in process module B on the other side of slit valve chamber 4. Placing pumps (not shown) on compartment X reduces the amount of gas from compartment X that diffuses to slit valve chamber 4. Placing pumps on compartment Y further reduces diffusion of gas from compartment W to compartment Z. Compartments X and Y have pumps attached and may therefore be considered pump compartments. By separating process compartments such as W and Z by pump compartments and a slit valve chamber, sputtering compartments of neighboring process modules are largely isolated from each other. However, in order to provide this isolation between process modules, one compartment on either side of the slit valve chamber is used for pumping and is not available for processing.

Figure 2 also shows rollers 8 in each compartment that provide support for substrates as they are moved through the coater. Rollers extend laterally across the compartments to support the entire width of the substrates. The arrows of Figure 2 show the path along which a substrate is moved through the coater as it is processed, substrate passline 10. In general, movement of substrates through the coater is at a constant speed with all rollers rotating at the same rate. Maintenance slit valves between process modules are normally open to allow substrates to pass from one process module to the next. Thus, one process module is in fluid communication with its neighbors during normal operation and gas flow between sputtering compartments of neighboring process modules is limited by the restricted size of the opening between process modules and the location of pumps on either side of the opening.

Slit valves may have different mechanisms, but generally work on the principle of moving a gate to cover an opening and sealing the gap between the wall and the gate with an o-ring. Various mechanisms may be used to move a gate between the open position and the closed position. A gate may rotate in a hinge-like manner or slide from one position to another. Slit valves are widely used in various industries including the semiconductor industry. However, in most semiconductor applications (and some glass coating applications), slit valves isolate a process chamber from a transfer chamber or loadlock during processing and only open to allow movement of a substrate into or out of the process chamber. In contrast, maintenance slit valves in a coater are located between process modules and remain open during normal processing. Also, slit valves for semiconductor applications are designed to handle substrates of 300milimeters (12 inches) or less in diameter, whereas coater slit valves may handle substrates as large as 3.2 meters (126 inches) wide, and are therefore much bigger.

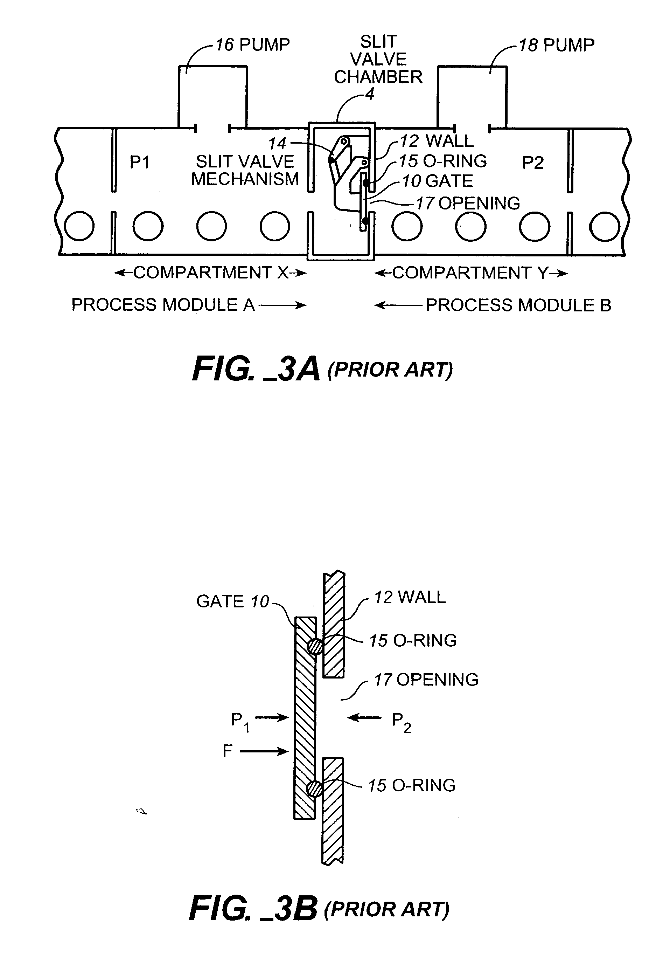

Figure 3A shows slit valve chamber 4 of Figure 2 in cross-section with portions of process module A and process module B visible. Slit valve chamber 4 has a slit valve (shown in the closed position) that includes a gate 10 that covers an opening 17 in the wall 12 and a slit valve mechanism 14 for moving gate 10. O-ring 15 seals between wall 12 and gate 10. Slit valve chamber 4 is shown located between two process modules A and B, with the compartments nearest to the slit valve on either side (compartments X and Y) having pumps 16, 18 mounted on top. The slit valve is shown in the closed position which is normally only used for maintenance. In Figure 3A, process modules A and B are isolated by the slit valve allowing one process module to be brought to atmospheric pressure for maintenance while the other process module remains under vacuum. Of course, there are other slit valves (not shown) at the other ends of process modules A and B that can isolate process modules A and B from neighboring process modules at the other ends.

Figure 3B illustrates the forces on the gate 10 of Figure 3A when one of the process modules is vented. P1 is the pressure in process module A, P2 is the pressure in process module B and F is the force exerted by slit valve mechanism 14 to maintain the seal between wall 12 and gate 10. If process module A is vented, P1 is atmospheric pressure (approximately 14.7 pounds per square inch) and P2 is some much smaller pressure (millitorr range). P2 is generally negligible compared to atmospheric pressure. So, atmospheric pressure forces the gate against the wall, pressing o-ring 15 against the sealing surface of wall 12 and providing a good seal. In this case, little or no force is required from slit valve mechanism 14 and so F may be very small or even zero, while still maintaining a good seal. This may be referred to closing gate 10 the "easy way" because atmospheric pressure works with gate 10 to provide a good seal.

If process module B is vented in Figure 3A, then P2 is atmospheric pressure and P1 is some much smaller pressure. In this case, slit valve mechanism 14 must exert a force sufficient to overcome P2 (atmosphere) and press o-ring 15 against the sealing surface of wall 12. For a large slit valve such as those used in coaters, opening 17 may be as wide as 135 inches and is typically 1.75 inches high giving an area of about 236 square inches. Thus the force of atmospheric pressure would be about 236 x 14.7 = 3473lbs for such a slit valve. A slit valve mechanism must overcome this force merely to keep the gate in position. In addition, the slit valve must exert enough force to keep the o-ring compressed against the sealing surface surrounding the opening. Thus, the force F for a slit valve this size must be thousands of pounds. This may be referred to as closing the slit valve the "hard way" because atmospheric pressure works against the slit valve.

Slit valves have been successfully designed that work both the easy way and the hard way. However, adjusting a slit valve to work both ways requires considerable skill and generally requires more maintenance than is desirable. Such slit valves tend to leak if they are not adequately maintained. Leaks are especially common when the slit valve must close the hard way. The large forces needed may contribute to the tendency of these slit valves to leak by putting mechanical components under considerable stress.

An alternative prior art design of slit valve chamber is shown in Figure 4. This shows a slit valve chamber 20 with two walls 22, 24, each wall having an opening 26, 28 that can be blocked by a movable gate 30, 32. Figure 4 shows gates 30, 32 in the closed position. In the open position, gates 30, 32 move inward and clear of openings 26, 28 to allow substrates to pass through. This arrangement has the advantage over the example of Figure 3A and 3B that it is symmetric so that there no difference between overall valve performance between venting one process module or the other. However, this system has certain limitations. Access to the slit valve mechanisms may be difficult if the space between walls is small. If the space is made larger for maintenance access, the slit valve chamber may take up too much room and add to the length of the coater. In addition, rollers are needed between the walls if the gap between the walls is too great. Typically, substrates must be supported every 12 inches, so rollers are placed not more than 12 inches apart. Since this chamber needs to be isolated from each of the adjacent chambers, a separate vacuum feedthrough and drive mechanism are installed to control the rollers of this section of the conveyor.

Therefore, there is a need for a slit valve chamber to provide isolation between process chambers that is easier to maintain. There is also a need for a slit valve chamber that does not add greatly to overall coater length and preferably allows a reduction in length while maintaining a high degree of gas isolation between process modules during processing.

According to one aspect of the invention, a dual gate slit valve has a gate on either side of an opening so that the gates close over the opening from opposite sides. When one side of the dual gate slit valve is vented to atmospheric pressure, the gate on the side that is vented is pressed against the wall surrounding the opening by atmospheric pressure, helping to seal the opening. The other gate separates two volumes that are both under vacuum and so experience little or not force from the pressure difference. The dual gate slit valve is symmetric so that whichever side is vented, the gate on the vented side will be held closed by atmospheric pressure (closed the easy way). Neither gate has to be forced closed against atmospheric pressure (closed the hard way). Less force is required to close such valves and the mechanism for closing the valves can be adjusted accordingly. Less maintenance is required for such valves because parts are under less load and atmospheric pressure works with the gate to seal the opening instead of

According to another aspect of the invention, a dual gate slit valve chamber has a central wall running vertically through the middle to dive the chamber into two portions connected by an opening through which substrates can pass which can be sealed by a dual gate slit valve. One or more pumps can be mounted on the slit valve chamber. Pumps are mounted over the slit valve mechanism so that the pumps and slit valve mechanisms overlap along the substrate passline, thus reducing overall system length. Pumps are mounted on either side of the central wall to provide sources of vacuum to process modules on either side of the slit valve chamber. Pumps on either side are separately controlled to allow pumps on one side to maintain vacuum while the pumps on the other side are shut down for venting.

The dual gate slit valve chamber may have rollers to support substrates in the slit valve chamber and move them forward along the substrate passline. Rollers in the slit valve chamber can be connected to rollers in adjacent process modules so that they share the same source of mechanical power. Typically, a belt or chain within the vacuum environment provides coupling between rollers. This reduces the number of vacuum feedthroughs needed to keep all rollers in the system rotating.

In yet another aspect of the invention, a dual gate slit valve chamber has endwalls with openings to allow substrates to pass through and pumping slots to allow gas to flow from adjacent process modules to the pumps mounted to the dual gate slit valve chamber. The gas flow around the substrate openings is reduced by keeping the substrate openings small and providing baffles that form a gas isolation tunnel extending into the slit valve chamber from the substrate openings. The pumping slots are located near the pumps to promote gas flow from the process modules to the pumps through the pumping slots. Thus, gas flow from the process modules is directed away from the opening in the central wall, towards the pumps. This reduces gas flow from one process module to another so that a process in one process module is not adversely affected by a process in another process module.
Various features and advantages of the invention will be apparent from the following description of embodiments thereof, in which reference is made to the accompanying drawings wherein:

Figure 1 shows a coater of the prior art (already discussed)

Figure 2 shows a cut-away view of a portion of the prior art coater of Figure 1.

Figure 3A shows a cut-away view of a slit valve chamber and portions of process modules of the prior art coater of Figures 1 and 2.

Figure 3B illustrates the forces on the gate of the prior art slit valve of Figure 3A when one side is at atmosphere and the other is under vacuum.

Figure 4 shows an alternative prior art slit valve chamber and the forces acting on it when one side is at atmospheric pressure and the other is under vacuum.

Figure 5 illustrates a dual gate slit valve according to an embodiment of the present invention and the forces acting upon the gates of the dual gate slit valve.

Figure 6 shows a cross-section of a dual gate slit valve chamber according to an embodiment of the present invention.

Figure 7 shows a top-view of the dual gate slit valve chamber of Figure 6.

Figure 8 shows the dual gate slit valve chamber and portions of adjacent process modules, with pumps attached to the slit valve chamber and belts connecting rollers in the slit valve chamber to rollers of adjacent process modules.

Figure 9 shows another dual gate slit valve chamber in the open position.

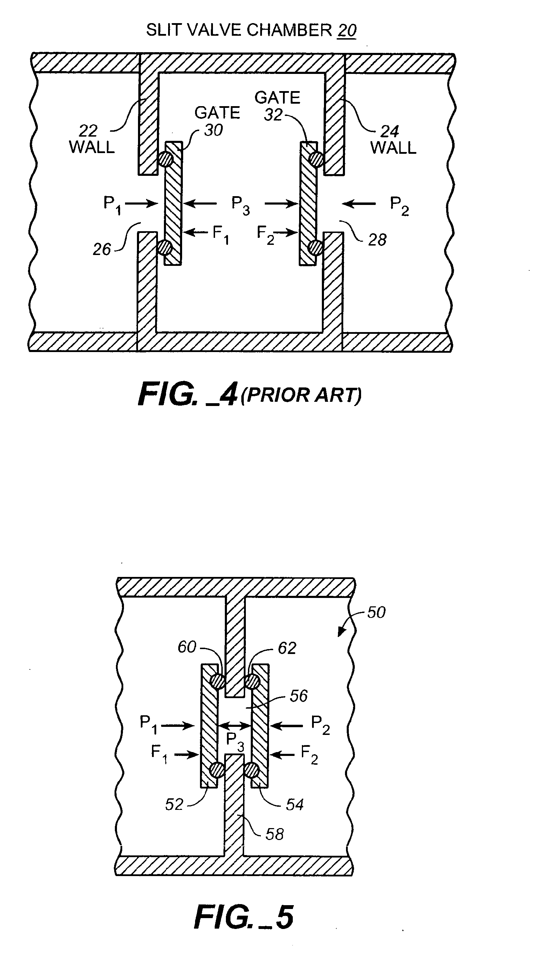

Figure 5 shows a simplified cross-sectional view of a dual gate slit valve 50 according to an embodiment of the present invention. In contrast to the slit valve arrangement shown in Figure 4, Figure 5 shows two gates 52, 54 covering a single opening 56 in a wall 58 from either side. In this arrangement, atmospheric pressure is effectively used to seal one side the easy way any time a process module is vented on either side of dual gate slit valve 50. P1 and P2 represent the pressures on either side of dual gate slit valve 50. F1 and F2 represent the forces applied to gates 52 and 54 respectively.

If the process module on the left is vented in Figure 5, then P1 is atmospheric pressure while P2 remains at some very small pressure. The pressure P3 in opening 56 between gate 52 and gate 54 will generally be equal to P2 because opening 56 was open to both process modules prior to venting. Thus, gate 52 is closed the easy way with atmospheric pressure forcing gate 52 against wall 58 and forcing o-ring 60 against the sealing surface of wall 58. At the same time, gate 54 experiences little or no pressure difference between P2 and P3 so that it may also keep o-ring 62 compressed and maintain an effective seal. Thus, the arrangement of Figure 5 has two seals in series, one of which has atmospheric pressure working to improve the seal, the other having little or no pressure working against it. Figure 5 shows force F1 applied to gate 52 and force F2 applied to gate 54. However, in the closed position shown, F1 may be small or even zero because atmospheric pressure P1 forces gate 52 against the wall. F2 may also be very small because there is little or no pressure difference between the two sides of gate 54. Thus, two effective barriers to gas flow are provided, one on either side of opening 56, without requiring large forces. Because the forces applied by the slit valve mechanism (not shown) may be relatively small, the forces and resulting strain on components of the slit valve mechanism may be reduced. Unlike certain prior slit valves, slit valve 50 of Figure 5 does not have to maintain a gate in a closed position against atmospheric pressure. For example, neither F1 nor F2 in Figure 5oppose the force of atmospheric pressure and so both F1 and F2 may be less than the force that would be needed to oppose atmospheric pressure.

Dual gate slit valve 50 of Figure 5 is symmetric about the plane of wall 58. Therefore, there is no difference in the ease of sealing depending on which side of dual gate slit valve 50 is vented. If the process module on the right is vented, P2 is atmospheric pressure and P1 is much less than atmospheric pressure so that the situation described above is reversed. Here, atmospheric pressure helps to keep gate 54 closed and keep o-ring 62 sealed against wall 58. Thus, regardless of which process module is vented, large forces are not needed to keep the slit valve sealed.

In the embodiment of Figure 5, opening 56 forms a small isolated volume between gate 52 and gate 54. However, no moving parts or other components are located in this volume, so access to this area is not critical. Instead of having a large central volume that is isolated from the adjacent process modules when vented (as in prior art of Figure 4), the interior volume of a chamber containing dual gate slit valve 50 is partitioned into two portions, each of which is open to the adjacent process module and is vented with the adjacent process module and only a small isolated cavity is formed between the gate52 and gate 54 by opening 56. In some embodiments, the isolated volume of opening 56 may be reduced further by providing a narrow wall, or a narrow portion of wall 58 where gates 52, 54 seal.

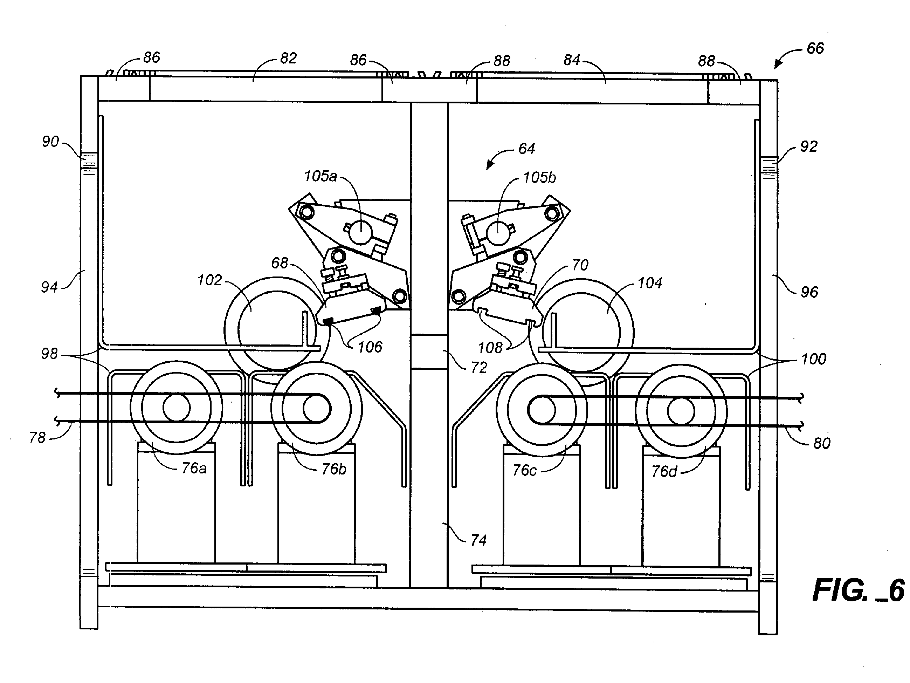

Figure 6 shows an embodiment of the present invention where a dual gate slit valve 64 is located within a dual gate slit valve chamber 66 used for isolating process modules during maintenance. Dual gate slit valve 64 is shown in the open position with both gates 68, 70 moved back from opening 72 in wall 74. Wall 74 in this example is approximately 2 inches thick and does not have any other openings. In general, both gates 68 and 70 are moved together so that in the open position they are both moved back from opening 72 and in the closed position they both cover opening 72. However, for maintenance or other reasons, gates 68, 70 may be individually moved.

Figure 6 shows rollers 76a-76d in dual gate slit valve chamber 66. Rollers 76a-76d are used to support substrates while they are in the coater and also move the substrates through the coater. Rollers 76a-76d are generally powered by electrical motors. A servomotor located on the outside of the coater (at atmospheric pressure) may be used to power one or more rollers. In the present example, multiple rollers are linked together so that they rotate at the same speed. This linkage may be within the vacuum environment of the coater, so that only one coupling from atmosphere to vacuum is needed for a group of linked rollers. In one example, a servomotor at atmospheric pressure is provided for each process module with belts or chains used to couple rollers of individual compartments within the process module. Servomotors of different process modules of a coater must be synchronized so that substrates move through the system at a constant rate and do not hit each other. Therefore, the servomotors of all process modules of a coater may be placed under the control of a central controller that synchronizes all the motors to a predetermined speed. While the rollers for a slit valve chamber of the present invention may be separately powered, this generally requires a servomotor and a mechanical feedthrough to couple mechanical power from atmosphere to vacuum. In the embodiment shown in Figure 6, rollers 76a, 76b on one side of dual gate slit valve chamber 66 are rotated by a belt 78 that supplies mechanical power from a neighboring process module. Belt 78 extends from rollers 76a, 76b of dual gate slit valve chamber 66 to rollers in the adjacent process module. Belt 78 may be within the process module and dual gate slit valve chamber 66 (under vacuum) and not outside (at atmospheric pressure), thus reducing the need for coupling mechanical power from atmospheric pressure to vacuum. Rollers on each side of the partition may be coupled to the process module on their respective sides of the slit valve chamber. Belt 78 is provided to power rollers 76a, 76b on one side of dual gate slit valve chamber 66 and a separate belt 80 is provided to power rollers 76c, 76d on the other side of dual gate slit valve chamber 66.

On the top of dual gate slit valve chamber 66 there are pump openings 82, 84 and pump flanges 86, 88 for attachment of pumps. Pump flange 86 is shown on one side of the central wall 74 (partition) of dual gate slit valve chamber 66 with pump flange 88 on the other side. Additional pump flanges (not shown) may be present with pumps spaced out in the direction perpendicular to the cross-section of Figure 6. By placing pumps in the locations shown, attached to flanges 86 and 88, space may be saved in the coater. In particular, by placing the pumps on a slit valve chamber such as dual gate slit valve chamber 66, it may be unnecessary to have pumps on the compartments next to the slit valve chamber. Thus, for a coater with N slit valve chambers, this potentially frees up 2N compartments for use as process compartments that were formerly needed as pumping compartments. This is a considerable saving in space. By placing the pumps over the slit valve mechanism, the length of the coater may be reduced compared with prior coaters because of the overlap of the pumps with the slit valves. Alternatively, the openings for the pumps may be blanked off and pumps may be mounted to the process module as before.

Placing the pumps on a slit valve chamber allows the neighboring process modules to be pumped through the opening in the end wall through which the substrate passes. However, this is not generally desirable because it draws potential contaminants from a process module across a substrate towards the slit valve and so towards the next process module. To facilitate pumping from the neighboring process modules, additional openings may be formed between a slit valve chamber and the neighboring process modules. Figure 6 shows pumping slots (pump slots) 90, 92 in each end wall 94, 96 of dual gate slit valve chamber 66 for this purpose. Pumping slots 90, 92 are another key component of the Dual Gate Slit Valve chamber 66. In certain previous slit valve art (Figure 4), it is not possible to have these pumping slots because the ability of the maintenance valve to isolate a non-vented compartment from an adjacent vented compartment would be lost, as these slots would bypass the sealing being done by the slit valve. Conversely, with the placement of central wall 74 in the new design, the appropriately located pumping slots on the end walls 94, 96 provide an identical profile to that which is used in a normal pumping compartment. Pumping slots 90, 92 are located towards the top of dual gate slit valve chamber 66 near the pump flanges 86, 88 to facilitate flow of gas to the pumps. When it is necessary to vent up a process module, the pumps in the slit valve chamber that service that process module are switched off but the pumps for other process modules may remain on. Thus, the pumps on either side of central wall 74 of dual gate slit valve chamber 66 may be separately controlled so that the pumps on either side can be independently turned off.

Figure 6 shows gas isolation shielding extending around the substrate path to form gas isolation tunnels 98, 100. Gas isolation tunnels 98, 100 minimize the diffusion of gases through dual gate slit valve chamber 66 during normal operation of the coater by providing a very small opening through the slit valve chamber along the substrate passline. By reducing the flow of gases through dual gate slit valve chamber 66, cross-contamination between process modules is kept to a minimum. Thus, the combination of gas isolation tunnels 98, 100 and pumping slots 90, 92 directs gases from process modules towards the pumps mounted to flanges 86, 88 of dual gate slit valve chamber 66 while keeping gas flow around the substrate at a low level, thereby reducing gas flow from one process module to the next.

Viewports 102, 104 are shown behind part of the gas isolation tunnel. Viewports 102, 104 allow a technician to see what is happening inside dual gate slit valve chamber 66 without having to vent the chamber. Thus, a viewport may be used to see if the substrates are being processed normally. The position of the slit valve gates 67, 70 may be seen through the viewports 102, 104. The locations of viewports 102, 104 may be determined to allow viewing of the most critical parts of dual gate slit valve chamber 66.

The slit valve mechanisms of Figure 6 are driven by shafts 105a, 105b that run in a direction perpendicular to the plane of the cross-section shown. Shafts 105a, 105b rotate to move gates 68, 70 between the open position and the closed position. In the open position shown, gates 68, 70 are clear of opening 72 in wall 74 to allow substrates to pass through opening 72. Gates 68, 70 are mounted to arms that rotate about an axis and ensure that gates 68, 70 are parallel to wall 74 in the closed position. An o-ring 106 is shown on gate 68. No o-ring is shown on gate 70 to more clearly show the groove 108 that holds an o-ring on gate 70. In normal operation, groove 108 holds an o-ring. The surface of wall 74 against which the o-ring seals are polished to ensure a good seal.

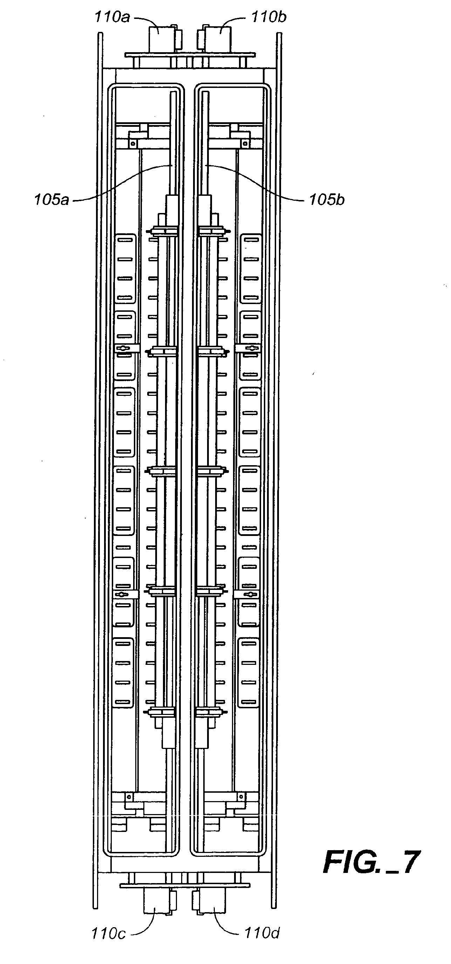

Figure 7 shows a top-view of dual gate slit valve chamber 66. This shows the shafts 105a, 105b extending outside vacuum (into atmospheric pressure). Actuators 110a-110d that rotate shafts 105a, 105b are outside vacuum for ease of access. The actuators may be pneumatic, electrical or use some other mechanism to rotate shafts105a, 105b. A coating system may be as wide as 185 inches (15 feet, 5 inches) and the shafts extend outside this to couple to the actuators. Actuators 110a-110d are shown on either end of shafts 105a, 105b to provide even torque along the shafts. While a particular type of slit valve and slit valve mechanism are shown, aspects of the present invention may be practiced with any kind of slit valve that uses a gate to cover an opening in a wall and seals against the wall.

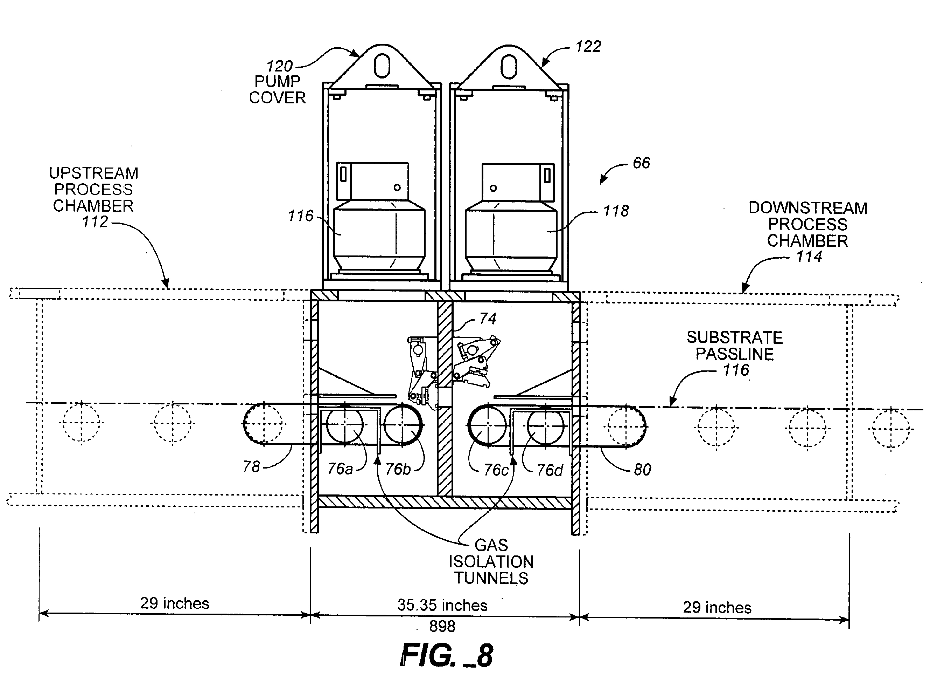

Figure 8 shows dual gate slit valve chamber 66 connected to adjacent process modules 112, 114. The path of substrates passing through the system (substrate passline 116) is indicated, going from upstream process module 112 through dual gate slit valve chamber 66 to downstream process module 114. Rollers are provided in both process modules 112, 114 and in dual gate slit valve chamber 66 to support and move the substrates through the coater. Rollers 76a-76d in dual gate slit valve chamber 66 are connected to the rollers of adjacent process modules 112, 114 by belts 78, 80 so that no separate rotational power is needed for dual gate slit valve chamber 66. No belts extend through central wall 74 in dual gate slit valve chamber 66. Various belt configurations may be used to couple rollers. Alternatively some other mechanical coupling components may be used. For example, a chain or shaft may be used to mechanically couple rollers within a vacuum.

Figure 8 shows pumps 116,118 and pump covers 120,122 over dual gate slit valve chamber 66 on both sides of central wall 74. This stacking of pumps 116, 118 over dual gate slit valve chamber 66 provides efficient use of space while maintaining low cross contamination from gases diffusing between process modules 112, 114. Pumps 116, 118 are tubromolecular pumps (turbo pumps) that are used in conjunction with backing pumps such as dry pumps or blowers. Multiple turbo pumps can be mounted on each side of central wall 74 of dual gate slit valve chamber 66 by spacing them apart in the direction perpendicular to the cross section shown. Multiple turbo pumps may share a backing pump. The configuration shown allows all the pumps on one side of the slit valve chamber to be shut down for venting while keeping the turbo pumps on the other side running to maintain vacuum. Thus, pump 116 and pump 118 may be separately controlled.

The space saving that is possible using aspects of the present invention may be seen from Figure 8. The length of dual gate slit valve chamber 66 of Figure 8 is approximately 35 inches. This 35-inch-long chamber provides isolation between process modules 112 and 114 during maintenance and also provides pumping during routine operation. In contrast, certain prior arrangements have required a slit valve chamber with a compartment on either side dedicated as pumping compartments to provide these functions. Where a pump compartment measures 29 inches and a single gate slit valve chamber measures 24 inches along the substrate passline, this totals about 82 inches. Thus, a saving of 47 inches may be achieved by using a dual gate slit valve chamber compared with using a single gate slit valve chamber and two pump compartments. For systems with multiple slit valve chambers, this saving is multiplied accordingly.

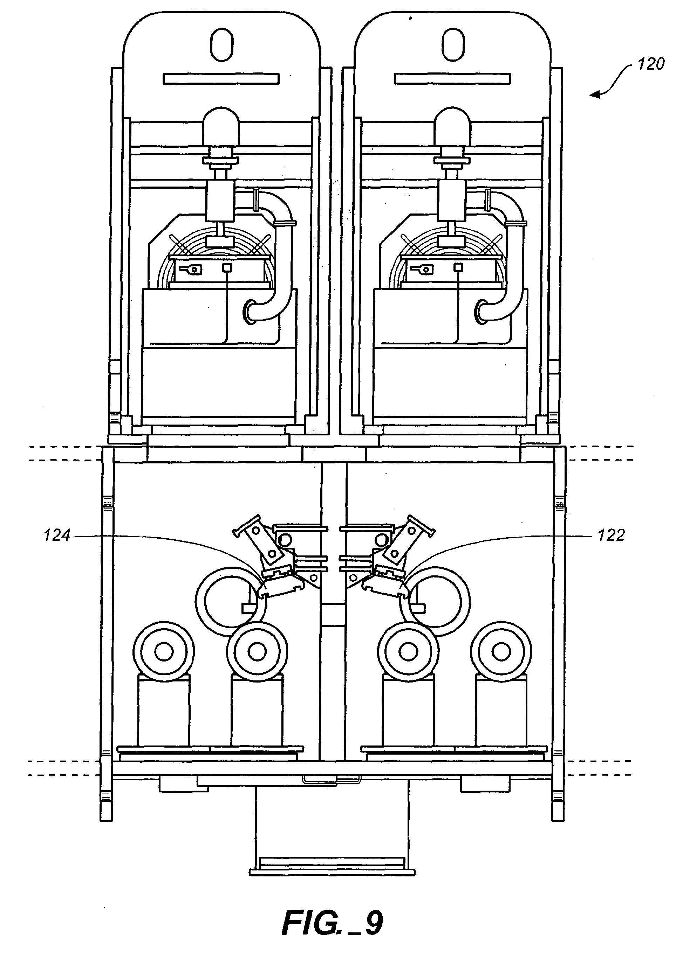

Figure 9 shows a cross-section of a dual gate slit valve chamber 120 that is similar to dual gate slit valve chamber 66. Dual gate slit valve chamber 120 is shown with both gates 122, 124 in the open position. T his is the normal position for gates 122, 124 during processing of substrates so that substrates can pass through dual gate slit valve chamber. The pressure on either side of dual gate slit valve chamber 120 is approximately the same when gates 122, 124 are in the open position. Only when one or both of gates 122, 124 are in the closed position can a substantial pressure difference exist.

Although the present invention has been described in terms of specific embodiments, it will be understood that the invention is not limited to the embodiments described and is entitled to protection within the full scope of the claims.

## Claims

1. A gas isolation valve for isolating adjacent process modules in a coating system having multiple sequential process modules, comprising:
a wall separating a first enclosed volume from a second enclosed volume, the wall having a first surface, a second surface and an opening extending from the first surface to the second surface;
a first movable gate that seals against the first surface and extends across the opening to close the opening; and
a second movable gate that seals against the second surface and extends across the opening to close the opening.

2. The gas isolation valve of claim 1 further comprising a substrate transfer path passing through the opening and passing over rollers positioned on either side of the wall.

3. The gas isolation valve of claim 1 wherein the gas isolation valve is normally open during processing but is closed during maintenance.

4. A gas isolation chamber for isolating adjacent modules of a vacuum system when one of the modules is at atmospheric pressure and the other module is not at atmospheric pressure, comprising:
a partition that divides the gas isolation chamber into a first portion and a second portion, the partition having an opening that extends between the first portion and the second portion;
a first gate in the first portion;
a first mechanism that moves the first gate to cover the opening and seal against the partition;
a second gate in the second portion; and
a second mechanism that moves the second gate to cover the opening and seal against the partition.

5. The gas isolation chamber of claim 4 further comprising one or more vacuum pumps attached to the gas isolation chamber to evacuate the first portion.

6. The gas isolation chamber of claim 5 wherein the one or more vacuum pumps are located above part of the first mechanism.

7. The gas isolation chamber of claim 4 further comprising a roller in the first portion that supports a substrate passing through the opening.

8. The gas isolation chamber of claim 7 wherein the roller receives rotational power from outside the gas isolation chamber through a mechanical linkage.

9. The gas isolation chamber of claim 8 wherein the mechanical linkage extends between the roller and another rotating part in a process module that is in fluid communication with the first portion.

10. The gas isolation chamber of claim 4 further comprising a first end wall at one end of the chamber and a second end wall at the opposite end of the chamber, the first and second end walls separating the chamber from neighboring process chambers, the first and second end walls each having a substrate opening through which a substrate passes and a pumping opening through which gas passes.

11. The gas isolation chamber of claim 4 further comprising gas isolation shielding extending from the first and second end walls around the substrate opening to form a gas isolation tunnel.

12. A method of isolating a first process module from a second process module, comprising:
providing a maintenance chamber between the first process module and the second process module, the maintenance chamber having a partition that has an opening for substrate transfer between the first process module and the second process module;
providing a first gate that closes against a first side of the partition, the first gate covering the opening in a first position and uncovering the opening in a second position;
providing a second gate that closes against a second side of the partition the gate covering the opening in a first position and uncovering the opening in a second position, the second side being opposite to the first side; and
providing vacuum pumping in the maintenance chamber such that gas flows from the first process module into the maintenance chamber and from the second process module into the maintenance chamber.

13. The method of claim 12 further comprising closing the first and second gates, venting the first process module to atmospheric pressure and maintaining the second process module at a subatmospheric pressure.
